# EUROPÄISCHE PATENTSCHRIFT

(11) **EP 1 687 847 B1**
(45) Veröffentlichungstag und Bekanntmachung des Hinweises auf die Patenterteilung: **07.03.2007**
(21) Anmeldenummer: 04786876.5
(22) Anmeldetag: 29.09.2004
(51) Int. Cl.: H01L 21/68, H01L 21/00

(54) **ANORDNUNG ELEKTRONISCHER HALBLEITERBAUELEMENTE AUF EINEM TRÄGERSYSTEM ZUR BEHANDLUNG DER HALBLEITERBAUELEMENTE MIT EINEM FLÜSSIGEN MEDIUM**
ARRANGEMENT OF ELECTRONIC SEMICONDUCTOR COMPONENTS ON A CARRIER SYSTEM FOR TREATING SAID SEMICONDUCTOR COMPONENTS WITH A LIQUID MEDIUM
DISPOSITION DE COMPOSANTS ELECTRONIQUES A SEMI-CONDUCTEUR SUR UN SYSTEME DE SUPPORT, AFIN DE TRAITER LES COMPOSANTS A SEMI-CONDUCTEUR AVEC UNE MATIERE LIQUIDE

(30) Priorität: 26.11.2003 DE 20318462 U
(43) Veröffentlichungstag der Anmeldung: 09.08.2006
(73) Patentinhaber: Infineon Technologies AG, 81669 München (DE)
(72) Erfinder: BRADL, Stephan, 93051 Regensburg (DE); METZL, Michael, 93073 Neutraubling (DE); SCHWAIGER, Josef, 93356 Teugn (DE); STACHE, Thilo, 93059 Regensburg (DE)
(74) Vertreter: Hudler, Frank
(86) Internationale Anmeldenummer: PCT/DE2004/002164
(87) Internationale Veröffentlichungsnummer: WO 2005/053014

(56) Entgegenhaltungen:
- EP-A- 0 866 494
- EP-A- 1 083 589
- EP-A- 1 202 326
- PATENT ABSTRACTS OF JAPAN Bd. 2000, Nr. 23, 10. Februar 2001 (2001-02-10) -& JP 2001 156039 A (DAINIPPON SCREEN MFG CO LTD), 8. Juni 2001 (2001-06-08)

## Beschreibung

Die Erfindung betrifft eine Anordnung elektronischer Halbleiterbauelemente auf einem Trägersystem zur Behandlung der Halbleiterbauelemente mit einem flüssigen Medium, wobei das Halbleiterbauelement mit seiner aktiven Seite auf dem Trägersystem so lösbar montiert ist, dass die Anordnung zumindest im Randbereich und abschnittsweise zwischen den Halbleiterbauelementen und dem Trägersystem einen Spalt aufweist.

Die Anordnung eines elektronischen Halbleiterbauelements mit der aktiven Seite nach unten (Face-down) auf einem Trägersystem, so dass sich zwischen dem Halbleiterbauelement und dem Trägersystem entsprechend der Topografie des Halbleiterbauelements zumindest abschnittsweise ein Rand befindet, ist in der Halbleitertechnologie sehr häufig anzutreffen. Dabei ist der Spalt entweder verfahrenstechnisch erforderlich und das den Spalt umfließende Medium wird so gewählt, dass der Spalt unter dem Einfluss seiner Kapillarwirkung optimal ausgefüllt wird, wie zum Beispiel zur Unterfüllung des elektronischen Halbleiterbauelements in der Flip-Chip-Technologie.

Oder die Kapillarwirkung des Spalts führt zu unerwünschtem Unterfließen des flüssigen Mediums unter das Halbleiterbauelement. In jedem Fall hängt die Kapillarwirkung bekanntermaßen von der Breite des Spaltes und der Oberflächenspannung des flüssigen Mediums als dessen werkstofftypische Eigenschaft ab.

Das Unterfließen des Halbleiterbauelements insbesondere durch ein Ätzmedium ist zu verhindern, da es bei der Face-down-Montage des Halbleiterbauelements auf dessen aktiver Seite zu undefiniertem Anätzen und dadurch zur Schädigung und auch zur Zerstörung des elektronischen Halbleiterbauelements führen kann.

Wachsende Bedeutung erfährt dieser Aspekt in der Dünnscheibentechnologie, da immer größere Scheiben immer kostengünstiger und dünner produziert werden und immer höhere Anforderungen an das produktsichere Handling der Dünnscheiben stellen. Das erfordert die Entwicklung von Trägertechnologien, die ein sicheres Dünnscheibenhandling innerhalb der Fertigung zulassen.

Das Handling der elektronischen Halbleiterbauelemente, in diesem Fall im Wafer-Verband, auf einem Trägersystem, führt insbesondere beim Wafer-Dünnen durch Schleifen unter Anwesenheit eines flüssigen Schleifmediums und durch nasschemisches Rückseitenätzen des Wafers zu der beschriebenen Beeinflussung der aktiven Seite der elektronischen Halbleiterbauelemente, die sich bei Face-down-Anordnung der Wafer auf dem Trägersystem innerhalb des Spaltes befindet und infolge der Kapillarwirkung des Spaltes ebenfalls der aggressiven Medien ausgesetzt ist.

Bisher wird der Schädigung der Halbleiterbauelemente durch häufiges Wechseln des Trägersystems oder durch kurzfristiges Handling der dünnen Scheiben minimiert, was jedoch, auch aufgrund der Bruchanfälligkeit der dünnen Wafer-Scheiben, zu besonderem Arbeitsaufwand und erhöhten Kosten führt.

Eine weitere Möglichkeit, die aktive Seite der Wafer vor den aggressiven Medien zu schützen, besteht gegenwärtig in dem Bekleben dieser Seite mit Adhesiv-Folie. Jedoch limitiert das Folienmaterial den für den weiteren Prozess zur Verfügung stehenden Temperaturbereich drastisch, in der Regel auf unter 100°C. Ein weiterer wesentlicher Nachteil dieses Verfahrens besteht darin, dass das Erfordernis; die Folie wieder zu entfernen, eine bestimmte Dicke der Dünnscheibe erfordert, die groß genug sein muss, den mechanischen Kräften beim Ablösen der Folie zu widerstehen. Diese Bedingung beschränkt die Dicke der Dünnscheiben gegenwärtig auf ca. 100 µm. Zukünftige Technologien erfordern allerdings weit geringere Wafer- und Bauelementedicken.

"In der Anmeldung EP-A- 1 202 326 wird beispielsweise eine Vorrichtung zur Flüssigkeitsbehandlung von Wafern offenbart bei der die Flüssigkeit durch Kapillarkräfte im Randbereich des Wafers gehalten wird, beschreibt aber keine Profilierung des Trägersystems"

Somit liegt der Erfindung die Aufgabe zugrunde, eine lösbare Anordnung elektronischer Halbleiterbauelemente auf einem mechanisch stabilen Trägersystem zum produktsicheren Handling der Halbleiterbauelemente im Fertigungsprozess darzustellen, bei der die Kapillarwirkung des Spalts zwischen den Halbleiterbauelementen und dem Trägersystem kontrolliert vermindert und somit der schädigende Einfluss eines in den Spalt kriechenden flüssigen Mediums verhindert wird.

Erfindungsgemäß wird die Aufgabe dadurch gelöst, dass die Oberfläche des Trägersystems eine Profilierung aufweist, die den Spalt in dessen gesamten Randbereich erweitert. Bekanntermaßen hängt die Eindringtiefe in einen als Kapillare wirkenden Spalt neben den Benetzungseigenschaften der im Spalt anliegenden Materialien, also der elektronischen Halbleiterbauelemente und des Trägersystems, sowohl von den Eigenschaften des anliegenden flüssigen Mediums, insbesondere der Oberflächenspannung, als auch von der Breite des Spalts ab. Während sich die Eindringtiefe proportional zur Oberflächenspannung des Mediums verhält, besteht eine invers proportionale Beziehung zwischen der Eindringtiefe und der Spaltbreite.

Da auf die Materialien der elektronischen Halbleiterbauelemente und des Trägersystems nur in einzelnen Fällen so Einfluss genommen werden kann, dass die Eindringtiefe des Mediums in den Spalt verringert wird und auch das flüssige Medium von den Verfahrensparametern abhängig ist, wird die genannte Beziehung zwischen der Eindringtiefe und der Spaltbreite ausgenutzt und durch die erfindungsgemäße, lokal begrenzte Aufweitung des Spaltes zwischen dem elektronischen Halbleiterbauelement und dem Trägersystem in seinem Randbereich das Eindringen des am Spalt anliegenden fließbaren Mediums unterbunden oder zumindest kontrolliert.

Diese Anordnung ermöglicht somit die Anwendung eines Trägermediums, welches mechanisch und thermisch stabil ist und sich nicht der Topografie der Halbleiterbauelemente anpassen muss, um einen Spalt zu vermeiden oder zumindest zu minimieren. Derartige Trägersysteme gewährleisten sowohl das sichere Handling im Fertigungsprozess auf grund ihrer eigenen, dafür erforderlichen Stabilität als auch die mechanische Befestigung auf dem Trägersystem sowie das anschließende Demontieren der Halbleiterbauelemente. So kann die mechanische Befestigung zum Beispiel mit bekannten und geeigneten Verfahren, wie dem Punktkleben oder dem Punktlaserschweißen erfolgen.

Die Form der Aufweitung des Spaltes hängt im Wesentlichen von der Topografie der dem Spalt zugewandten, aktiven Seite der Halbleiterbauelemente ab. Ist diese zum Beispiel eben oder zumindest nahezu eben, erfolgt die Aufweitung ausschließlich durch die Profilierung des Trägersystems. Ist hingegen eine Verjüngung auf der Spaltseite im Randbereich der Halbleiterbauelemente vorhanden, kann diese bereits als teilweise Spaltaufweitung betrachtet und in die gewünschte Form des Spaltrandes einbezogen werden.

Auch vom Spaltrand aus in den Spalt hinein verlaufende Vertiefungen in der dem Spalt zugewandten Oberfläche der elektronischen Halbleiterbauelemente sind bei der Gestaltung der randnahen Aufweitung des Spaltes zu berücksichtigen. Bei stark strukturierten Oberflächen kann es durchaus möglich sein, dass das Einfließen des flüssigen Mediums in den Spalt nicht vollständig verhindert, sondern hinsichtlich der Tiefe oder hinsichtlich bestimmter Spaltabschnitte lediglich vermindert oder kontrollierbarer wird.

Eine besondere Ausgestaltung der Erfindung sieht vor, dass die Erweiterung des Spalts zwischen dem elektronischen Halbleiterbauelement und dem Trägersystem durch eine Rille ausgeführt ist, welche sich im Wesentlichen parallel zum Spaltrand erstreckt. Solch eine Rille wird insbesondere bei gering strukturierten Halbleiterbauelementeoberflächen anwendbar sein und kann beispielsweise mit einfachen mechanischen oder auch nasschemischen Verfahren in verschieden gestaltete Trägersysteme auch an bestimmten Abschnitten der Oberfläche eingebracht werden, so dass die Gestalt des Trägersystems nicht der der Halbleiterbauelemente entsprechen muss.

Auch die Ausgestattung des Trägersystems mit mehreren solcher Rillen, die nach Form und Größe bestimmten, standardisierten elektronischen Halbleiterbauelementen entsprechen ist somit möglich, so dass ein Trägersystem flexibler einsetzbar ist.

In einer günstigen Ausführungsform der Erfindung hingegen entspricht die Form und die Größe des Trägersystems im Wesentlichen der Form und Größe des elektronischen Halbleiterbauelements und die Erweiterung des Spalts zwischen dem elektronischen Halbleiterbauelement und dem Trägersystem ist durch eine Phase an der dem elektronischen Halbleiterbauelement zugewandten Kante des Trägersystems ausgeführt. In dieser Ausführung wird verhindert, dass eine bestimmte, nicht unerhebliche Menge des aggressiven, flüssigen Mediums auf einer Oberfläche vor dem Spalt verbleibt und durch besondere Umstände das nachträgliche Hineinfließen des Mediums in den Spalt ungewollt begünstigt wird.

Sofern sich entsprechend einer erfindungsgemäßen Ausgestaltung die elektronischen Halbleiterbauelemente im Wafer-Verband befinden, lässt sich aufgrund der Scheibenform der elektronischen Halbleiterbauelemente das Trägersystem besonders günstig hinsichtlich der Gestalt anpassen und im Randbereich des Spaltes profilieren. Häufig kann als Trägersystem ein nicht verdünnter Silizium-Wafer verwendet werden. In diesem Fall kann die Phase am Rand des als Trägersystem dienenden Trägerwafers oder die Rille auf dessen Oberfläche mit den erprobten, kostengünstigen Verfahren eingebracht werden und es steht ein Trägersystem zur Verfügung, welches selbst in hohem Grad eben ist.

Aus diesem Grund findet diese Ausführungsform bei dem beschriebenen Wafer-Dünnen Anwendung, wo es aufgrund der geringen endgültigen Dicken des zu bearbeitenden Wafers auf die ebene Unterlage ankommt. Erfolgt das Wafer-Dünnen beispielsweise durch das bekannte Spin-Etching, ist das Trägersystem eine rotationssymmetrische, drehbar gelagerte Platte. Hierbei ist das flüssige Medium ein Ätzmedium und wird auf einen rotierenden Wafer im Bereich der Rotationsachse aufgebracht, verteilt sich mit Hilfe der Fliehkräfte gleichmäßig über die Rückseite des Wafers und führt so zu dem gewünschten gleichmäßigen Materialabtrag.

Das durch die Fliehkräfte an den Rand des Wafers transportierte Ätzmedium umfließt dessen Kante und wird wegen der erfindungsgemäßen Aufweitung des Spaltes zwischen dem zu bearbeitendem Wafer und dem Trägersystem am Unterfließen des Wafers und am den Wafer beschädigenden Unterätzen gehindert.

Diese speziellen Ausführungsformen der Erfindung finden auch im mechanischen Wafer-Dünnen Anwendung. Hierbei ist das flüssige Medium jedoch die Schleifflüssigkeit, welche Schleifpartikel und Materialpartikel enthält und somit ebenfalls daran zu hindern ist, aufgrund der Kapillarwirkung des Spaltes zwischen den Wafer und das Trägersystem zu fließen und dort Schädigungen des Wafers zu verursachen.

In einer besonders günstigen Ausgestaltung der Erfindung ist vorgesehen, dass sich die Breite der Erweiterung des Spaltes danach bemisst, dass für ein definiertes flüssiges Medium und für definierte Materialien der elektronischen Halbleiterbauelemente und des Trägersystems die Eindringtiefe in den nach der Erweiterung folgenden Spalt zumindest nahezu Null ist. Wie eingangs dargestellt, haben die Kenngrößen dieser Material ebenfalls Einfluss auf die Eindringtiefe des flüssigen Mediums in den Spalt.

Sowohl die den Spalt bildenden Materialien der elektronischen Halbleiterbauelemente und des Trägersystems können nur in einzelnen Fällen hydrophob ausgeführt sein und somit die Kapillarwirkung unterdrücken als auch das flüssige Medium selbst wird in der Regel durch die Anforderungen des Prozesses bestimmt sein. Aber bei Kenntnis der die Kapillarwirkung bestimmenden Eigenschaften dieser Materialien, des Benetzungsverhaltens und der Oberflächenspannung, und der Kenntnis weiterer Einflussgrößen kann die Eindringtiefe des flüssigen Mediums in den Spalt sehr gut über die Breite und die Tiefe der Aufweitung des Spaltes eingestellt werden. Solche weiteren Einflussfaktoren wären beispielsweise die Fliehkraft im Spin-Etching-Verfahren, die der Kapillarkraft entgegen wirkt und einfach regelbar ist. Somit ist für definierte Anwendungsfälle die Einwirkung des anliegenden flüssigen Mediums gezielt zu kontrollieren.

Die Erfindung soll nachfolgend anhand eines Ausführungsbeispieles näher erläutert werden. Die zugehörige Zeichnung zeigt in
- Fig. 1: eine schematische Teilschnittdarstellung der erfindungsgemäßen Anordnung auf einem Chuck mit rillenförmiger Spaltaufweitung und
- Fig. 2: eine schematische Teilschnittdarstellung der erfindungsgemäßen Anordnung mit einer Spaltaufweitung durch eine Phase.

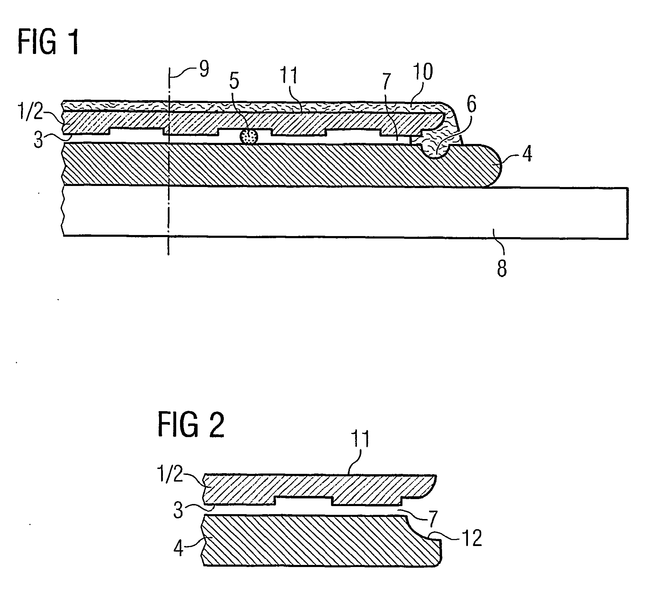

In der erfindungsgemäßen Anordnung elektronischer Halbleiterbauelemente 1 auf einem Trägersystem 4, wie es schematisch in Fig. 1 dargestellt ist, sind die Halbleiterbauelemente 1 im Wafer-Verband mit der aktiven, eine Struktur aufweisenden Seite 3 nach unten (Face down) auf einem runden Trägersystem 4 durch Punktkleben montiert, so dass nur an einigen Stellen Kleberkugeln 5 die Verbindung zwischen dem Halbleiterbauelement 1, in diesem Ausführungsbeispiel dem Wafer 2, und dem Trägersystem 3 lösbar herstellen.

Der Durchmesser des Trägersystems 4 ist größer als der Durchmesser des Wafers 2. Auf dem Durchmesser, der ungefähr dem des Wafers 2 entspricht, weist das Trägersystem 4 eine Rille 6 mit halbkreisförmigem Querschnitt auf, deren Tiefe im dargestellten Ausführungsbeispiel ungefähr der Höhe des Spaltes 7 zwischen dem Wafer 2 und dem Trägersystem 4 entspricht, so dass der Spalt 7 im Bereich der Rille 6 auf die doppelte Breite vergrößert ist.

Das Trägersystem 4 wiederum ist mittels Vakuum auf einem Vakuumchuck 8 fixiert. Der Vakuumchuck 8 weist ebenso wie das Trägersystem 4 und der Wafer 2 eine Kreisform auf. Alle drei Bestandteile dieser Anordnung sind um eine Rotationsachse 9 drehbar angeordnet, so dass das im Bereich der Rotationsachse 9 während der Rotation aufgebrachte flüssige Ätzmedium 10 nach einer gewissen Zeit in einer nahezu gleichmäßigen Verteilung auf der Rückseite 11 des Wafers 2 vorhanden ist.

Das über den Rand des Wafers 2 hinaustretende Ätzmedium 10 umfließt den Rand und füllt den Randbereich des Spaltes 7 zwischen dem Wafer 2 und dem Trägersystem 4 einschließlich der dort ausgebildeten Rille 6 aus und tritt lediglich in sehr geringem Maße über die Rille 6 hinaus in den Spalt 7 ein.

Fig. 2 stellt eine andere Ausführungsform der Profilierung des Trägersystems 4 dar, wobei das Trägersystem 4 nahezu die gleiche Größe aufweist wie die elektronischen Halbleiterbauelemente 1. Erfindungsgemäß ist es in solch einem Fall möglich, dass das Trägersystem 4 eine Phase 12 an der den Halbleiterbauelementen 1 zugewandten Kante aufweist, die in der dargestellten Ausführung nahezu den Querschnitt eines Viertelkreises aufweist und die Dicke des Trägersystems 4 an seiner Außenkante auf ungefähr die Hälfte reduziert.

### Anordnung elektronischer Halbleiterbauelemente auf einem Trägersystem zur Behandlung der Halbleiterbauelemente mit einem flüssigen Medium

### Bezugzeichenliste

- 1: Halbleiterbauelement
- 2: Wafer
- 3: aktive Seite
- 4: Trägersystem
- 5: Kleberkugeln
- 6: Rille
- 7: Spalt
- 8: Vakuumchuck
- 9: Rotationsachse
- 10: Ätzmedium
- 11: Rückseite
- 12: Phase

## Patentansprüche

1. Anordnung elektronischer Halbleiterbauelemente auf einem Trägersystem zur Behandlung der Halbleiterbauelemente mit einem flüssigen Medium, wobei das Halbleiterbauelement mit seiner aktiven Seite auf dem Trägersystem so lösbar montiert ist, dass die Anordnung zumindest im Randbereich und abschnittsweise zwischen den Halbleiterbauelementen und dem Trägersystem einen Spalt aufweist, **dadurch gekennzeichnet, dass** die Oberfläche des Trägersystems (4) eine Profilierung aufweist, die den Spalt (7) in dessen gesamten.Randbereich erweitert.

2. Anordnung elektronischer Halbleiterbauelemente auf einem Trägersystem nach Anspruch 1, **dadurch gekennzeichnet, dass** die Erweiterung des Spalts (7) zwischen dem elektronischen Halbleiterbauelement (1) und dem Trägersystem (4) durch eine Rille (6) ausgeführt ist, welche sich im Wesentlichen parallel zum Rand des Spalts (7) erstreckt.

3. Anordnung elektronischer Halbleiterbauelemente auf einem Trägersystem nach Anspruch 1, **dadurch gekennzeichnet, dass** die Form und die Größe des Trägersystems (4) im Wesentlichen der Form und Größe der elektronischen Halbleiterbauelemente (1) entspricht und dass die Erweiterung des Spalts (7) zwischen den elektronischen Halbleiterbauelementen (1) und dem Trägersystem (4) durch eine Phase (12) an der den elektronischen Halbleiterbauelementen (1) zugewandten Kante des Trägersystems (4) ausgeführt ist.

4. Anordnung elektronischer Halbleiterbauelemente auf einem Trägersystem nach einem der Ansprüche 1 bis 3, **dadurch gekennzeichnet, dass** sich die elektronischen Halbleiterbauelemente (1) im Wafer-Verband befinden.

5. Anordnung elektronischer Halbleiterbauelemente auf einem Trägersystem nach Anspruch 4, **dadurch gekennzeichnet, dass** das Trägersystem (4) eine rotationssymmetrische, drehbar gelagerte Platte ist.

6. Anordnung elektronischer Halbleiterbauelemente auf einem Trägersystem nach Ansprüche 1 bis 5, **dadurch gekennzeichnet, dass** das flüssige Medium ein Ätzmedium (10) ist.

7. Anordnung elektronischer Halbleiterbauelemente auf einem Trägersystem nach einem der Ansprüche 1 bis 6 **dadurch gekennzeichnet, dass** sich die Breite der Erweiterung des Spalts (7) danach bemisst, dass für ein definiertes flüssiges Medium und für definierte Materialien der elektronischen Halbleiterbauelemente (1) und des Trägersystems (4) die Eindringtiefe in den nach der Erweiterung folgenden Spalt (7) zumindest nahezu Null ist.

## Claims

1. Arrangement of electronic semiconductor components on a carrier system for treating said semiconductor components with a liquid medium, the semiconductor component being detachably mounted with its active side on the carrier system in such a way that the arrangement comprises a gap at least in the edge region and in certain portions between the semiconductor components and the carrier system, **characterized in that** the surface of the carrier system (4) has a profiling, which widens the gap (7) in its entire edge region.

2. Arrangement of electronic semiconductor components on a carrier system according to claim 1, **characterized in that** the widening of the gap (7) between the electronic semiconductor component (1) and the carrier system (4) is created by a channel (6) which extends substantially parallel to the edge of the gap (7).

3. Arrangement of electronic semiconductor components on a carrier system according to claim 1, **characterized in that** the form and size of the carrier system (4) corresponds substantially to the form and size of the electronic semiconductor component (1) and **in that** the widening of the gap (7) between the electronic semiconductor component (1) and the carrier system (4) is created by a phase (12) on the edge of the carrier system (4) that is facing the electronic semiconductor component (1).

4. Arrangement of electronic semiconductor components on a carrier system according to one of claims 1 to 3, **characterized in that** the electronic semiconductor components (1) are in the wafer array.

5. Arrangement of electronic semiconductor components on a carrier system according to claim 4, **characterized in that** the carrier system (4) is a rotationally symmetrical, rotatably mounted plate.

6. Arrangement of electronic semiconductor components on a carrier system according to one of claims 1 to 5, **characterized in that** the liquid medium is an etching medium (10).

7. Arrangement of electronic semiconductor components on a carrier system according to one of claims 1 to 6, **characterized in that** the width of the widening of the gap (7) is dimensioned on the basis that the depth of penetration into the gap (7) for a defined liquid medium and for defined materials of the electronic semiconductor components (1) and of the carrier system (4) following the widening is at least virtually zero.

## Revendications

1. Arrangement de composants électroniques semiconducteurs sur un système porteur destiné au traitement des composants semiconducteurs avec un milieu liquide, le composant semiconducteur étant monté avec son côté actif sur le système porteur de manière amovible de telle sorte que l'arrangement présente un interstice au moins dans la zone de bordure et par sections entre les composants semiconducteurs et le système porteur, **caractérisé en ce que** la surface du système porteur (4) présente un profil qui élargit l'interstice (7) dans la totalité de sa zone de bordure.

2. Arrangement de composants électroniques semiconducteurs sur un système porteur selon la revendication 1, **caractérisé en ce que** l'élargissement de l'interstice (7) entre le composant électronique semiconducteur (1) et le système porteur (4) est réalisé par une gorge (6) qui s'étend pour l'essentiel parallèlement au bord de l'interstice (7).

3. Arrangement de composants électroniques semiconducteurs sur un système porteur selon la revendication 1, **caractérisé en ce que** la forme et la taille du système porteur (4) correspondent pour l'essentiel à la forme et à la taille des composants électroniques semiconducteurs (1) et l'élargissement de l'interstice (7) entre les composants électroniques semiconducteurs (1) et le système porteur (4) est réalisé par une phase (12) sur l'arête du système porteur (4) qui fait face aux composants électroniques semiconducteurs (1).

4. Arrangement de composants électroniques semiconducteurs sur un système porteur selon l'une des revendications 1 à 3, **caractérisé en ce que** les composants électroniques semiconducteurs (1) se trouvent dans une structure en galette.

5. Arrangement de composants électroniques semiconducteurs sur un système porteur selon la revendication 4, **caractérisé en ce que** le système porteur (4) est une plaque à symétrie rotationnelle logée de manière à pouvoir tourner.

6. Arrangement de composants électroniques semiconducteurs sur un système porteur selon l'une des revendications 1 à 5, **caractérisé en ce que** le milieu liquide est un milieu corrosif (10).

7. Arrangement de composants électroniques semiconducteurs sur un système porteur selon l'une des revendications 1 à 6, **caractérisé en ce que** la largeur de l'élargissement de l'interstice (7) est dimensionnée de telle sorte que la profondeur de pénétration dans l'interstice (7) obtenue après l'élargissement pour un milieu liquide donné et pour des matériaux donnés des composants électroniques semiconducteurs (1) et du système porteur (4) est au moins quasiment nulle.
